(19) Europäisches Patentamt
European Patent Office
Office européen des brevets

(11) **EP 2 741 240 B1**

(12) **EUROPEAN PATENT SPECIFICATION**

(45) Date of publication and mention
of the grant of the patent:
**14.02.2018 Bulletin 2018/07**

(51) Int Cl.:
***G06K 19/073*** *(2006.01)*     ***H01L 23/58*** *(2006.01)*
***G06K 19/07*** *(2006.01)*     ***G06K 19/077*** *(2006.01)*

(21) Application number: **12306556.7**

(22) Date of filing: **10.12.2012**

(54) **A secure chip module and a method of making the same**

Sicheres Chip-Modul und Herstellungsverfahren dafür

Module à puce de sécurité et procédé de fabrication de celui-ci

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**11.06.2014 Bulletin 2014/24**

(73) Proprietor: **Oberthur Technologies
92700 Colombes (FR)**

(72) Inventors:
• **Morin, Nicolas
92300 LEVALLOIS-PERRET (FR)**
• **Giraud, Christophe
92300 LEVALLOIS-PERRET (FR)**
• **Andouard, Philippe
92300 LEVALLOIS-PERRET (FR)**

(74) Representative: **Santarelli
49, avenue des Champs-Elysées
75008 Paris (FR)**

(56) References cited:
**US-A1- 2005 253 228     US-A1- 2008 003 883
US-A1- 2008 003 883**

## Description

## Field of the Invention

The current invention relates to a secure chip module and a method of making a chip module and in particular but not exclusively the invention relates to a chip module that is resistant to attacks by a laser that is used to corrupt the chip module of a smart card.

## Background of the Invention

Smart cards are typically laminated cards which have electronic chip modules incorporated in the body of the card to allow for communication with other devices such as payment or banking systems. Data held on the card, typically about the bearer of the card can be transmitted from the card to the third party device.

To manufacture a data carrier such as a smart card, the chip module has to be incorporated very precisely in the card so that it cannot be easily removed. Also during manufacture, where the chip module is embedded in the card, there needs to be precise positioning of the chip module with contacts that are embedded in the card so communication can occur. To incorporate a chip module in a card, firstly the card which provides the support for the chip module is machined so that a cavity is formed for receiving the chip module in the card and then the chip module is glued in place in the cavity.

Due to the sensitive nature of the information that may be stored on chip modules in smart cards it may be necessary to protect these devices from reverse engineering in the event that a system containing them were to fall into the wrong hands. Typically, persons wanting to gain information or corrupt a smart card use a laser that they direct at a chip on the card to cause a fault in the chip. The laser beam is composed of photons that alter the properties in the semiconductor material, such as silicon that makes up the chip. The semiconductor becomes more conductive when exposed to light and this can make transistors on the chip the chip. Modification on the chip can then be used by someone wanting to corrupt the chip and steal information to bypass some of the security elements that a manufacturer has put on the chip.

Typically, the security of a chip has been enhanced by providing a shield on the active face of the chip. In US 2012/0088338 the chip is coated in a silicate glass material that has nano-particles in it to form a high durability coating. However, with enough laser power there is still the risk that photons can get through the shielding layer and the chip can be corrupted. The inclusion of very specific materials such as nanoparticles can also lead to more complicated and slower manufacturing processes.

The present invention seeks to overcome the problems with the prior art by providing a low-cost simple method whereby reverse engineering of proprietary or secretive circuits or electronics packages is rendered difficult, impossible or nearly impossible by using a specific way of making a chip module and incorporating such a chip module in a data carrier such as a smart card.

## Summary of the Invention

According to a first aspect of the present invention there is provided a chip module in accordance with claim 1. Preferably, the outer face of the chip support is opposed to the active face of the chip.

The outer face of the chip preferably comprises the outside face of the chip support having the largest area.

The chip may be held to the chip support using a layer of adhesive which is thicker in one area than another area so that the active face of the chip is angled with respect to the outer face of the chip support.

There may be a chip support member positioned between the chip and the chip support, the chip support member including a first face in contact with the chip and a second face, opposite to the first face, in contact with the chip support, and the first face and the second face being angled one with respect to the other.

The chip support may comprise at least one electric contact connected to the chip via one or more contact tracks. The outer face of the chip support may comprise the at least one electric contact and an opposite face of the chip support may hold the chip. Alternatively, the outer and opposite faces of the chip support may be delimited by a peripheral surface, the peripheral surface carrying at least one electric contact.

The active face of the chip and the outer face of the chip support may be angled one with respect to the other preferably by a maximum of 10 degrees.

The chip module preferably further comprises a protective layer positioned between the chip support and the chip, the protective layer preferably comprising a ceramic plate.

The chip module may be covered by an encapsulate so forming an embeddable module. The encapsulate may comprise a resin epoxy cresol novolac with one or more fillers based on amorphous or crystalline silica and alumina and/or nanoparticles to deflect light directed at the chip module.

According to a second aspect of the present invention there is provided a data carrier having a support body with a receiving area in which a chip module according to the first aspect of the invention is mounted, characterised in that the chip is embedded in the support body with the active face of the chip angled relative to an outer face of the support body.

The receiving area may be a recess in the support body having a base and walls such that when the chip module is inserted in the recess, the active face of the chip is directed towards an inner part of the support body.

The data carrier may include an antenna and where the data carrier is provided as a SIM card, a bank card, a payment card, an identity card or a passport.

According to a third embodiment of the present invention there is provided a method in accordance with claim 16. According to a fourth embodiment of the present invention there is provided a method in accordance with claim 17.

Further variants of the invention are found in the dependent claims.

## Brief Description of the Figures

An embodiment of the invention will now be described by way of example only with reference to the accompanying figures in which:

Figure 1 shows: a sectional view of a chip module embedded in a support body according to the prior art;

Figure 2 shows: a chip module connected to a chip support according to a first embodiment of the invention;

Figure 3 shows: the angle of deflection using a chip module according to an embodiment as shown in Figure2;

Figure 4 shows: a chip module embedded in a card and having a resin protection layer;

Figure 5 shows: a chip module embedded in a card and having a ceramic protection layer; and

Figure 6, which is not part of the invention as claimed, shows: another type of chip module with pins rather than a contact plate.

## Detailed Description of Embodiments of the Invention

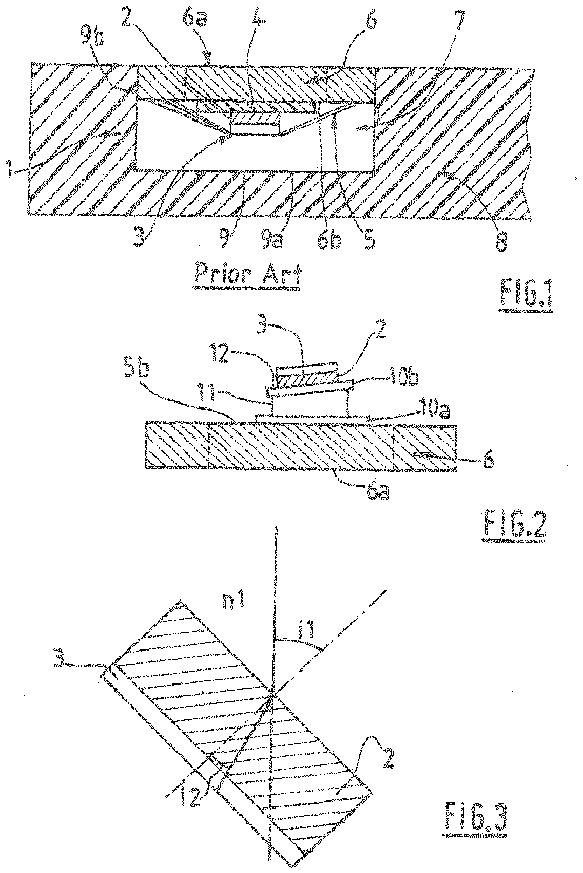

A chip module is generally shown as 1 in **Figure 1** and is formed of a microprocessor chip having a silicon body 2 with an etched (or active) face 3 (parts 2 and 3 collectively referred to as 10). The microprocessor chip is held on a chip support 6 by way of an adhesive layer on the face of a support body 8, which typically is a payment card such as a credit card. However the support body 8 is any type of body that carries data, such as a passport, an identity card or even a card that holds personal data such as a driving license. The chip module 1 is held in a recess 9 in the support body 8 with the recess 9 having a base 9a and side walls 9b. Once in situ in the recess 9 the chip module 1 is typically encased in a protective shield layer such as a resin encapsulate. As can be seen in this prior art arrangement, the contact plate 6 and the microprocessor chip 10 are parallel to one another. This is not ideal because if a fraudster wants to corrupt the chip 10 to gain access to data held on the chip 10 he will expose the chip module 1 to a laser beam, and as the chip 10 will be perpendicular to the beam the effect of the laser beam is optimal on the chip module 1 and corruption is more likely. Typically the data carrier according to the invention includes an antenna for communication with an external system such as a network or server and the data carrier is provided as a SIM card, a bank card, a payment card, an identity card or a passport.

**Figure 2** shows a chip module 1 according to an embodiment of the invention prior to being placed in a support body 8. As in the arrangement shown in **Figure 1,** the chip module 1 includes a silicon layer 2, an active face 3, and a chip support 6, the chip support preferably having one or more contact plates 6 located on an outer face 6a of the chip support 6. The outer face 6a of the chip support 6 is generally opposite, or opposed to, the active face 3 and is the face of the chip support 6 having the largest area. The chip support 6 is connected to the chip 10 by a first adhesive layer on a first flat face 10a of an additional chip support member 11. This additional chip support member 11 may be a build-up of adhesive layers or it may be a separate member that is placed between the chip 10 and the chip support 6 and/or contact plate 6. A second face 10b of the additional chip support member 11, opposite to the first face 10a, is inclined and an adhesive layer 12 may be placed on the inclined face 10b so that the silicon layer 2 of the chip 10 can be held on the additional chip support member 11. Said in another way, a first plane parallel to the active face 3 of the chip 10 is angled with respect to a second plane parallel to the outer face 6a of the chip support 6, the first and second planes being angled relative one another. The angle, or inclination, is more than 0 degrees, and in accordance with the invention as claimed between 1 and 15 degrees, and more preferably by a maximum of 10 degrees. When mounted in a support body 8 as discussed in relation to Figure 1, the active face 3 of the chip 10 is held at an angle to the axis of the support body 8. The axis of the support body 8 is that axis that runs along the longitudinal axis of the support body i.e. it is a plane of a flat body such as a credit or bank card. This may alternatively be expressed as the support body 8 having a third plane parallel to an outer face of the support body 8, with the first plane discussed above being angled relative to this third plane.

An attacker usually directs the light beam so that it strikes the chip 10 at an angle that is perpendicular to the contact plate 6 and because in known chip modules 1 the active face 3 of the chip 10 is parallel to the contact plate 6 the beam is directed with an angle of 90 ° relative to the chip module 1 (as shown by the thinnest dotted line in the **Figure 3**).

When a beam of light passes from one medium to another at an angle of incidence (or other material), it follows Snell's Law i.e.

$$n1 * \sin(i1) = n2 * \sin(i2)$$

(where n1 is the index of medium 1 (air) and n2 is the index of medium 2 (silicon).

In accordance with Snell's law if the silicon is at an angle to the incident light the light beam is deflected from its path when it comes in contact with the silicon surface. This means that an attacker does not know what part of the chip 10 is attacked. In addition, the fact that the beam hits an inclined surface means that there is deformation of the beam. Instead of having a small round spot, the beam spreads to form an oval (this is called "spread" beam). As a consequence of beam spreading it loses power density (W / $m^2$), and this reduces the intensity of light and reduces the disruption of photons so rendering the chip module 1 less prone to attack.

As shown if the light beam enters the substrate at an angle different from that of the vertical then the beam will be deflected in proportion to the angle of difference. Under these conditions, it is very difficult to determine the deviation and therefore know the point of impact of the beam on the active part. In addition, this beam deflection causes a change also of the shape of the latter. A laser beam is originally round, it will move towards a more oblong and larger. This will alter the surface of the active part affected by the light beam and therefore the power density of the beam (power density for power \ surface).

An attacker may try to corrupt a chip 10 from a front or rear attack. When attacked from the front the laser beam impinges first on the active face 3. If the chip 10 is attacked from the rear the laser beam is directed at the silicon body 2 first.

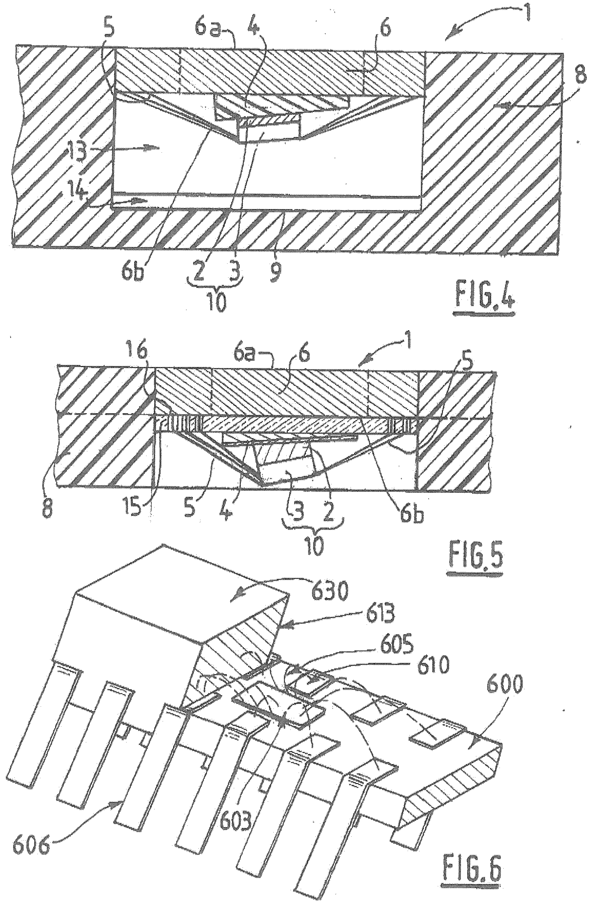

In **Figure 4** we see the chip module 1 embedded in a support body 8 which is in this case a bank card. The chip support 6, with one or more contact plates 6, has a chip 10 with an active face 3 mounted on it. Contact track/connectors 5 are located between the active face 3 and the contact plates 6. The chip module 1 and connectors 5 are encapsulated in a resin 13 and then this encapsulated body is positioned in a recess 9 in the support body 8. The encapsulated module is held in the recess 9 by adhesive layer 14 which is located at the base of the recess 9. The chip 10 usually is connected to the chip support, and contact plates 6, by an adhesive layer 4. The adhesive layer 4 is typically based on epoxy-based polymer. Following initial bonding of the chip 10 on the contact plate 6, the chip 10 is encapsulated in resin sets. The use of resin molding is used for packaging "classic" integrated circuits (e.g. DIPs). This resin is a composite polymer such as epoxy cresol novolac generally plus mineral filler based on amorphous or crystalline silica and alumina. This use of resin encapsulation has the advantage that is forms a sealed body around the chip 10 so the chip is more resistant to chemical attack (e.g. based on methylene chloride) and prevents an attacker from accessing the chip 10 to corrupt it. This is because the resin is much more resistant to being dissolved than the adhesives used in chip module manufacture.

The resin coating that is used produces tightly adhering hermetic (water impermeable) coatings capable of withstanding very high temperatures. The resin coating may be composed of alkali silicate glass with nanoparticle and or microparticle modifiers, including, but not limited to, alkaline earth carbonates or oxides, metal oxides, rare-earth metal oxides, and non-metal oxides. Aqueous alkali silicate composite solutions applied on or between surfaces of materials, dry to form tough, tightly adhering inorganic bonds that exhibit many desirable characteristics.

Other particles such as but not limited to diamond, aluminum nitride, and other inorganics may also be combined with aqueous alkali silicate based solutions and cured to form very hard and durable composites. Varying combination and concentrations of the various particles allows the production of composites with specific thermal expansion, durability, and adhesion properties. These composites have been shown to bond very well to integrated circuit materials, including but not limited to silicon, silica, silicon nitride, metals, and other inorganics. These alkali silicate glass coatings are very hard and corrosion resistant, making them extremely difficult to remove. Accordingly, it is desirable to add micro- and nano-particles to create a very hard glass composite coating that is difficult, impossible, or nearly impossible to mechanically remove without damaging the underlying integrated circuit. Therefore, many applications exist for utilizing these composites for reverse engineering protection of integrated circuits and/or electronics packages.

The chip 10 is glued to the chip support and the contact plates 6 using an adhesive 4 which may be a liquid or paste which is laid down using an adhesive delivery head having multiple needles which lay the adhesive down as a series of dots using needles having bores through which the adhesive is extruded. The needles are arranged in an array and if a chip 10 that is tilted is required, the array of needles may be changed so that there are needles with a thicker bore so that in one pass, more adhesive is laid down in some areas on the chip than the other. The area with the greater amount of adhesive will be raised with respect to the area where less adhesive is delivered.

Once the one set of chips is embedded and adhered in place the adhesive delivery head that delivers the adhesive/glue is repositioned, for example rotated each time a new chip module 1 is to be positioned so that the chip modules 1 are not located in the same orientation each time. By having a degree of randomness of the position of the chip module 1 this makes it more difficult for fraudsters to direct a laser at a card to corrupt the chip module 1 as they will have to know the orientation each time they use the laser so it can be directed at the chip module 1 in the most appropriate way.

It is also possible for a pressing head to include a ratchet mechanism so that each time the chip module 1 is positioned the pressing head (or part of the chip positioning apparatus) is caused to contact the chip module 1 as it sits in the glue in the receiving area and the pressing head/apparatus pushes harder in a particular location on the chip module 1 to cause it to tilt in the glue and then the glue is allowed to set so leaving the chip 10 at an angle to the contact plate 6.

The use of resin provides a way of preventing attack of the chip 10 on its active face 3. It is also possible to attack a card from the rear of the card where a laser beam is passed through the support body 8 from the surface where the contact plate 6 is located. **Figure 5** shows an arrangement where there is a contact plate 6 at a surface of a support body 8. Overlying a surface of the contact plate 6 that is directed towards the inner layers of the card is a protective layer 15 such as a ceramic plate and then an adhesive layer 4 is located on part of the ceramic plate so that chip 10, which silicon layer 2 and active face 3 can be attached to the contact plate 6 with the protective layer 15 forming an intermediate layer between the two. Contact track/connectors 5 pass from the active face 3 to the contact plate 6 and the ceramic layer 15 has apertures 16 that allow the connectors 5 to pass through. The ceramic layer 15 provides a very hard layer which forms a physical barrier to attacks on the chip 10. The ceramic layer 15 can be used to prevent a counterfeiter drilling into the contact plate 6 of a chip module 1 and prevent access by a counterfeiter that uses a laser to corrupt the chip 10 itself.

As can be seen in both **Figures 4** and **5** the chip 10 is inclined with respect to the axis of the contact plate 6 so that any laser beam directed perpendicularly to the support body 8 will be deflected at an angle so weakening the impact of the laser and therefore minimizing the risk of corruption of the chip 10.

**Figure** 6 illustrates an example not according to the invention as claimed in which the chip 610 is mounted in a dual in-line package (DIP). The chip 610 is mounted to a package substrate 600 that is typically a moulded plastic or ceramic, although any other appropriate material may be used. Bond wires 605 (analogous to tracks in the previous embodiments) electrically connect the active face 603 of the chip 610 to contact pins 606. The chip 610, bond wires 605 and a portion of each contact pin 606 are covered and/or encapsulated by a polymer overmould 613. As will be appreciated by those skilled in the art, the package substrate 600 and overmould 613 may be integrally formed in a single moulding action in which the chip 610 and bondwires are encapsulated. The chip 610 is mounted on the package substrate 600 such that the active face 603 of the chip 610 is inclined, or angled, relative to the upper outer surface 630 of the DIP package. Said in another way, a first plane parallel to the active face 603 of the chip 610 is angled, or inclined, with respect to a second plane parallel to the outer surface of the package substrate 600 and/or the outer surface 630 of the overmould, the first and second planes being inclined relative one another. This may be achieved by using any of the mounting means discussed above with respect to the embodiments of the present invention illustrated in Figures 2 to 5, or alternatively by inclining the chip 610 to a plane parallel to the intended plane of the upper surface 630 of the overmould 613 during an encapsulation/moulding process. Depending on whether the package substrate 600 and overmould 613 are formed separately or integrally in a single process step, either the package substrate 600 or the combined substrate and overmould may be considered analogous to the chip support referred to above in respect of Figures 2 to 5.

To clarify, in the embodiments discussed, typically the contact plate 6 is located on an outside surface of the card so there is the ability for the card to communicate with an external device. The chip module 1 is located internally in the card and is attached to the face of the contact plate 6 that is opposed to the outside face 6a. The card preferably is a bank card or other card that can identify a user that is trying to access a network such a telecommunication network. Typically such cards comply with IS0 7816.

**Claims**

1. A chip module (1) comprising a chip (10) and a chip support (6), the chip (10) being held to the chip support (6), the chip module being configured for insertion into a recess in a support body of a data carrier so that an outer face of this chip module is parallel to an outer face of this support body, *characterised in that* an active face (3) of the chip (10) and an outer face (6a) of the chip support (6) are angled one with respect to the other by between 1 and 15 degrees.

2. The chip module (1) according to claim 1, wherein the outer face (6a) of the chip support (6) is opposed to the active face (3) of the chip (10).

3. The chip module (1) according to any one of claims 1 or 2, wherein the chip (10) is held to the chip support (6) using a layer of adhesive (4) which is thicker in one area than another area so that the active face (3) of the chip (10) is angled with respect to the outer face (6a) of the chip support (6).

4. The chip module (1) according to any one of claims 1 to 2, further comprising a chip support member (11) positioned between the chip (10) and the chip support (6), the chip support member (11) including a first face (10b) in contact with the chip (10) and a second face (10a), opposite to the first face (10b), in contact with the chip support (6), and the first face (10b) and the second face (10a) being angled one with respect to the other.

**5.** The chip module (1) according to any one of claims 1 to 4, wherein the chip support (6) comprises at least one electric contact (6) connected to the chip (10) via one or more contact tracks (5).

**6.** The chip module (1) according to claim 5, wherein the outer face (6a) of the chip support (6) comprises the at least one electric contact (6) and an opposite face (6b) of the chip support (6) holds the chip (10).

**7.** The chip module (1) according to any one of the preceding claims wherein the active face (3) of the chip (10) and the outer face (6a) of the chip support (6) are angled one with respect to the other by a maximum of 10 degrees.

**8.** The chip module (1) according to any one of the preceding claims, further comprising a protective layer (15) positioned between the chip support (6) and the chip (10).

**9.** The chip module (1) according to claim 8, wherein the protective layer (15) comprises a ceramic plate.

**10.** The chip module (1) according to any one of the preceding claims, wherein the chip module (1) is covered by an encapsulate so forming an embeddable module.

**11.** The chip module (1) according to claim 10, wherein the encapsulate comprises a resin epoxy cresol novolac with one or more fillers based on amorphous or crystalline silica and alumina and/or nanoparticles, to deflect light directed at the chip module (1).

**12.** The chip module (1) according to any one of the preceding claims, wherein the outer face (6a) of the chip support (6) comprises the outside face of the chip support (6) having the largest area.

**13.** A data carrier having a support body (8) with a receiving area (9) in which a chip module (1) according to any one of the preceding claims is mounted, *characterised in that* the chip (10) is embedded in the support body (8) with the active face (3) of the chip (10) angled relative to an outer face (6a) of the support body (8).

**14.** A data carrier according to claim 13 wherein the receiving area (9) is a recess (9) in the support body (8) having a base (9a) and walls (9b) such that when the chip module (1) is inserted in the recess (9), the active face (3) of the chip (10) is directed towards an inner part of the support body (8).

**15.** A data carrier according to any one of claims 13 or 14 comprising an antenna and where the data carrier is provided as a SIM card, a bank card, a payment card, an identity card or a passport.

**16.** A method of assembling a chip (10) to a contact plate (6) *characterized in that* it comprises the steps of:

providing a contact plate (6) and a chip (10), placing an adhesive delivery head in a first orientation, delivering an adhesive (4) to a face of the contact plate (6) and / or a face of the chip (10) using said adhesive delivery head, wherein the amount of adhesive (4) being delivered is varied to provide a first adhesive profile so that when a chip (10) is placed on the contact plate (6), the chip (10) is held at an angle between 1 and 15 degrees with respect to the contact plate (6), placing the chip (10) on the contact plate (6) with the adhesive (4) in between, providing a further contact plate (6) and a further chip (10), placing the adhesive delivery head in a further orientation different from the first orientation, so that when adhesive (4) is delivered, the adhesive profile is different from the first adhesive profile.

**17.** A method of assembling a chip (10) to a contact plate (6) *characterised in that* it comprises the steps of:

providing a contact plate (6) and a chip (10), delivering an adhesive (4) to a face of the contact plate (6) and / or a face of the chip (10) using an adhesive delivery head, placing the chip (10) on the contact plate (6) with the adhesive (4) in between and pressing a pressing head towards the chip (10) so that the chip (10) is angled at a first angle between 1 and 15 degrees with respect to the contact plate (6), providing a further contact plate (6) and a further chip (10), delivering an adhesive (4) to a face of the further contact plate (6) and / or a face of the further chip (10) using the adhesive delivery head, placing the further chip (10) on the further contact plate (6) with the adhesive (4) in between and pressing the pressing head towards the further chip (10) so that the further chip (10) is angled at a further angle between 1 and 15 degrees with respect to the contact plate (6), said further angle being different from the first angle.

**18.** The method according to any one of claims 16 or 17 wherein the adhesive delivery head comprises an array of needles that can deliver varying amount of adhesive (4) to a face of the contact plate (6) and / or a face of the chip (10).

**19.** The method according to claim 18, wherein the array of needles have bores of varying size and / or can deliver adhesive at different rates so that an adhesive (4) layer having areas of different thickness is laid down.

**Patentansprüche**

**1.** Chipmodul (1), das einen Chip (10) und einen Chipträger (6) aufweist, wobei der Chip (10) an dem Chipträger (6) gehalten ist, wobei das Chipmodul zum Einsetzen in eine Ausnehmung in einem Trägerkörper eines Datenträgers gestaltet ist, so dass eine Außenfläche dieses Chipmoduls parallel zu einer Außenfläche dieses Trägerkörpers ist, **dadurch gekennzeichnet, dass** eine aktive Fläche (3) des Chips (10) und eine Außenfläche (6a) des Chipträgers (6) zwischen 1 bis 15 Grad gegeneinander abgewinkelt sind.

**2.** Chipmodul (1) nach Anspruch 1, wobei die Außenfläche (6a) des Chipträgers (6) der aktiven Fläche (3) des Chips (10) gegenüberliegt.

**3.** Chipmodul (1) nach einem der Ansprüche 1 oder 2, wobei der Chip (10) unter Verwendung einer Klebstoffschicht (4) an dem Chipträger (6) gehalten ist, die in einem Bereich dicker ist als in einem anderen Bereich, so dass die aktive Fläche (3) des Chips (10) gegenüber der Außenfläche (6a) des Chipträgers (6) abgewinkelt ist.

**4.** Chipmodul (1) nach einem der Ansprüche 1 bis 2, ferner aufweisend ein zwischen dem Chip (10) und dem Chipträger (6) angeordnetes Chiptrageelement (11), wobei das Chiptrageelement (11) eine erste Fläche (10b) in Kontakt mit dem Chip (10) und eine zweite Fläche (10a), gegenüber der ersten Fläche (10b), in Kontakt mit dem Chipträger (6) aufweist, und die erste Fläche (10b) und die zweite Fläche (10a) gegeneinander abgewinkelt sind.

**5.** Chipmodul (1) nach einem der Ansprüche 1 bis 4, wobei der Chipträger (6) mindestens einen elektrischen Kontakt (6) aufweist, der über eine oder mehrere Kontaktbahnen (5) mit dem Chip (10) verbunden ist.

**6.** Chipmodul (1) nach Anspruch 5, wobei die Außenfläche (6a) des Chipträgers (6) den mindestens einen elektrischen Kontakt (6) aufweist und eine gegenüberliegende Fläche (6b) des Chipträgers (6) den Chip (10) hält.

**7.** Chipmodul (1) nach einem der vorhergehenden Ansprüche, wobei die aktive Fläche (3) des Chips (10) und die Außenfläche (6a) des Chipträgers (6) um maximal 10 Grad gegeneinander abgewinkelt sind.

**8.** Chipmodul (1) nach einem der vorhergehenden Ansprüche, ferner aufweisend eine Schutzschicht (15), die zwischen dem Chipträger (6) und dem Chip (10) angeordnet ist.

**9.** Chipmodul (1) nach Anspruch 8, wobei die Schutzschicht (15) eine Keramikplatte aufweist.

**10.** Chipmodul (1) nach einem der vorhergehenden Ansprüche, wobei das Chipmodul (1) durch eine Einkapselung bedeckt ist, wodurch ein einbettbares Modul gebildet wird.

**11.** Chipmodul (1) nach Anspruch 10, wobei die Einkapselung ein Epoxy-Cresol-Novolac-Harz mit einem oder mehreren Füllstoffen auf der Basis von amorphem oder kristallinem Siliciumdioxid und Aluminiumoxid und/oder Nanopartikeln aufweist, um Licht, das auf das Chipmodul (1) gerichtet ist, abzulenken.

**12.** Chipmodul (1) nach einem der vorhergehenden Ansprüche, wobei die Außenfläche (6a) des Chipträgers (6) die außenliegende Fläche des Chipträgers (6) mit dem größten Bereich aufweist.

**13.** Datenträger mit einem Trägerkörper (8) mit einem Aufnahmebereich (9), in dem ein Chipmodul (1) nach einem der vorhergehenden Ansprüche montiert ist, **dadurch gekennzeichnet, dass** der Chip (10) in dem Trägerkörper (8) eingebettet ist, wobei die aktive Fläche (3) des Chips (10) gegenüber einer Außenfläche (6a) des Trägerkörpers (8) abgewinkelt ist.

**14.** Datenträger nach Anspruch 13, wobei der Aufnahmebereich (9) eine Ausnehmung (9) in dem Trägerkörper (8) mit einem Sockel (9a) und Wänden (9b) ist, so dass beim Einsetzen des Chipmoduls (1) in die Ausnehmung (9) die aktive Fläche (3) des Chips (10) zu einem inneren Teil des Trägerkörpers (8) hin gerichtet ist.

**15.** Datenträger nach einem der Ansprüche 13 oder 14, ferner aufweisend eine Antenne, und wobei der Datenträger als eine SIM-Karte, eine Bankkarte, eine Zahlungskarte, ein Personalausweis, oder ein Pass vorgesehen ist.

**16.** Verfahren zum Einbauen eines Chips (10) an eine Kontaktplatte (6), **dadurch gekennzeichnet, dass** es die Schritte aufweist:

Bereitstellen einer Kontaktplatte (6) und eines Chips (10),
Anordnen eines Klebstoffabgabekopfes in einer ersten Orientierung,

Abgeben eines Klebstoffs (4) auf eine Fläche der Kontaktplatte (6) und/oder eine Fläche des Chips (10) unter Verwendung des Klebstoffabgabekopfes, wobei die Menge des abgegebenen Klebstoffs (4) variiert wird, um einen erstes Klebstoffprofil bereitzustellen, so dass, wenn ein Chip (10) auf der Kontaktplatte (6) platziert wird, der Chip (10) in einem Winkel zwischen 1 und 15 Grad gegenüber der Kontaktplatte (6) gehalten wird,

Platzieren des Chips (10) auf der Kontaktplatte (6) mit dem Klebstoff (4) dazwischen,

Bereitstellen einer weiteren Kontaktplatte (6) und eines weiteren Chips (10),

Platzieren des Klebstoffabgabekopfes in einer weiteren Orientierung, die sich von der ersten Orientierung unterscheidet, so dass, wenn Klebstoff (4) abgegeben wird, sich das Klebstoffprofil von dem ersten Klebstoffprofil unterscheidet.

17. Verfahren zum Einbauen eines Chips (10) an eine Kontaktplatte (6), **dadurch gekennzeichnet, dass** es die folgenden Schritte aufweist:

Bereitstellen einer Kontaktplatte (6) und eines Chips (10),

Abgeben eines Klebstoffs (4) auf eine Fläche der Kontaktplatte (6) und/oder eine Fläche des Chips (10) unter Verwendung des Klebstoffabgabekopfes, Platzieren des Chips (10) auf der Kontaktplatte (6) mit dem Klebstoff (4) dazwischen und Pressen eines Anpresskopfes in Richtung des Chips (10), so dass der Chip (10) in einem ersten Winkel zwischen 1 und 15 Grad gegenüber der Kontaktplatte (6) abgewinkelt ist,

Bereitstellen einer weiteren Kontaktplatte (6) und eines weiteren Chips (10),

Abgeben eines Klebstoffs (4) auf eine Fläche der weiteren Kontaktplatte (6) und/oder eine Fläche des weiteren Chips (10) unter Verwendung des Klebstoffabgabekopfes,

Platzieren des weiteren Chips (10) auf der weiteren Kontaktplatte (6) mit dem Klebstoff (4) dazwischen, und

Pressen des Presskopfes in Richtung des weiteren Chips (10), so dass der weitere Chip (10) in einem weiteren Winkel zwischen 1 und 15 Grad gegenüber der Kontaktplatte (6) abgewinkelt ist, wobei dieser weitere Winkel unterschiedlich zu dem ersten Winkel ist.

18. Verfahren nach einem der Ansprüche 16 oder 17, wobei der Klebstoffabgabekopf eine Anordnung von Nadeln umfasst, die eine unterschiedliche Menge an Klebstoff (4) auf eine Fläche der Kontaktplatte (6) und/oder eine Fläche des Chips (10) abgeben können.

19. Verfahren nach Anspruch 18, wobei das Array von Nadeln Bohrungen unterschiedlicher Größe aufweist und/oder Klebstoff mit unterschiedlichen Raten abgeben kann, so dass eine Klebstoffschicht (4) mit Bereichen unterschiedlicher Dicke abgelegt wird.

**Revendications**

1. Module à puce (1) comprenant une puce (10) et un support de puce (6), la puce (10) étant retenue au support de puce (6), le module à puce étant configuré pour permettre une insertion dans un évidement dans un corps de support d'un support de données de telle sorte qu'une face externe de ce module à puce soit parallèle à une face externe de ce corps de support, *caractérisé en ce qu'*une face active (3) de la puce (10) et une face externe (6a) du support de puce (6) forment un angle l'une par rapport à l'autre compris entre 1 et 15 degrés.

2. Module à puce (1) selon la revendication 1, dans lequel la face externe (6a) du support de puce (6) est opposée à la face active (3) de la puce (10).

3. Module à puce (1) selon l'une quelconque des revendications 1 ou 2, dans lequel la puce (10) est retenue au support de puce (6) à l'aide d'une couche d'adhésif (4) qui est plus épaisse dans une zone que dans une autre zone de telle sorte que la face active (3) de la puce (10) forme un angle par rapport à la face externe (6a) du support de puce (6).

4. Module à puce (1) selon l'une quelconque des revendications 1 à 2, comprenant en outre un élément de support de puce (11) positionné entre la puce (10) et le support de puce (6), l'élément de support de puce (11) comprenant une première face (10b) en contact avec la puce (10) et une seconde face (10a), opposée à la première face (10b), en contact avec le support de puce (6), et la première face (10b) et la seconde face (10a) formant un angle l'une par rapport à l'autre.

5. Module à puce (1) selon l'une quelconque des revendications 1 à 4, dans lequel le support de puce (6) comprend au moins un contact électrique (6) raccordé à la puce (10) par le biais d'une ou de plusieurs pistes de contact (5).

6. Module à puce (1) selon la revendication 5, dans lequel la face externe (6a) du support de puce (6) comprend le ou les contacts électriques (6) et une face opposée (6b) du support de puce (6) supporte la puce (10) .

7. Module à puce (1) selon l'une quelconque des revendications précédentes, dans lequel la face active (3) de la puce (10) et la face externe (6a) du support de puce (6) forment un angle l'une par rapport à l'autre d'au maximum 10 degrés.

8. Module à puce (1) selon l'une quelconque des revendications précédentes, comprenant en outre une couche de protection (15) positionnée entre le support de puce (6) et la puce (10).

9. Module à puce (1) selon la revendication 8, dans lequel la couche de protection (15) comprend une plaque de céramique.

10. Module à puce (1) selon l'une quelconque des revendications précédentes, dans lequel le module à puce (1) est recouvert par un matériau d'encapsulation de sorte à former un module encastrable.

11. Module à puce (1) selon la revendication 10, dans lequel le matériau d'encapsulation comprend une résine époxy novolaque crésolique ayant une ou plusieurs charges à base de silice et d'alumine amorphes ou cristallines et/ou de nanoparticules, pour diriger de la lumière vers le module à puce (1).

12. Module à puce (1) selon l'une quelconque des revendications précédentes, dans lequel la face externe (6a) du support de puce (6) comprend la face extérieure du support de puce (6) ayant la zone la plus grande.

13. Support de données ayant un corps de support (8) avec une zone de réception (9) dans laquelle un module à puce (1) selon l'une quelconque des revendications précédentes est monté, *caractérisé en ce que* la puce (10) est intégrée dans le corps de support (8) avec la face active (3) de la puce (10) formant un angle par rapport à une face externe (6a) du corps de support (8) .

14. Support de données selon la revendication 13, dans lequel la zone de réception (9) est un évidement (9) dans le corps de support (8) ayant une base (9a) et des parois (9b) de telle sorte que, lorsque le module à puce (1) est inséré dans l'évidement (9), la face active (3) de la puce (10) est dirigée vers une partie interne du corps de support (8).

15. Support de données selon l'une quelconque des revendications 13 ou 14, comprenant une antenne et dans lequel le support de données est fourni sous la forme d'une carte SIM, d'une carte bancaire, d'une carte de payement, d'une carte d'identité ou d'un passeport.

16. Procédé d'assemblage d'une puce (10) à une plaque de contact (6) *caractérisé en ce qu*'il comprend les étapes consistant :

à fournir une plaque de contact (6) et une puce ,
à placer une tête de distribution d'adhésif dans une première orientation,
à distribuer un adhésif (4) à une face de la plaque de contact (6) et/ou à une face de la puce (10) à l'aide de ladite tête de distribution d'adhésif, dans lequel la quantité d'adhésif (4) qui est distribuée varie de sorte à fournir un premier profil d'adhésif de telle sorte que, lorsqu'une puce (10) est placée sur la plaque de contact (6), la puce (10) est tenue selon un angle compris entre 1 et 15 degrés par rapport à la plaque de contact (6),
à placer la puce (10) sur la plaque de contact (6) avec l'adhésif entre ces dernières,
à fournir une autre plaque de contact (6) et une autre puce (10),
à placer la tête de distribution d'adhésif dans une autre orientation différente de la première orientation de telle sorte que, lorsque l'adhésif (4) est distribué, le profil d'adhésif est différent du premier profil d'adhésif.

17. Procédé d'assemblage d'une puce (10) à une plaque de contact (6) *caractérisé en ce qu*'il comprend les étapes consistant :

à fournir une plaque de contact (6) et une puce ,
à distribuer un adhésif (4) à une face de la plaque de contact (6) et/ou à une face de la puce (10) à l'aide d'une tête de distribution d'adhésif,
à placer la puce (10) sur la plaque de contact (6) avec l'adhésif (4) entre ces dernières et
à presser une tête de pression vers la puce (10) de telle sorte que la puce (10) soit inclinée selon un premier angle compris entre 1 et 15 degrés par rapport à la plaque de contact (6),
à fournir une autre plaque de contact (6) et une autre puce (10),
à distribuer un adhésif (4) à une face de l'autre plaque de contact (6) et/ou à une face de l'autre puce (10) à l'aide de la tête de distribution d'adhésif,
à placer l'autre puce (10) sur l'autre plaque de contact (6) avec l'adhésif (4) entre ces dernières, et
à presser la tête de pression vers l'autre puce (10) de telle sorte que l'autre puce (10) soit inclinée selon un autre angle compris entre 1 et 15 degrés par rapport à la plaque de contact (6), ledit autre angle étant différent du premier angle.

18. Procédé selon l'une quelconque des revendications 16 ou 17, dans lequel la tête de distribution d'adhésif comprend une série d'aiguilles qui peuvent distribuer une quantité variable d'adhésif (4) à une face de la plaque de contact (6) et/ou à une face de la puce (10).

**EP 2 741 240 B1**

**19.** Procédé selon la revendication 18, dans lequel la série d'aiguilles présente des alésages de taille variable et/ou peut distribuer un adhésif à des vitesses différentes de telle sorte qu'une couche d'adhésif (4) présentant des zones d'épaisseur différente soit posée.

EP 2 741 240 B1

Prior Art

FIG.1

FIG.2

FIG.3

11

FIG.4

FIG.5

FIG.6

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20120088338 A